Europäisches Patentamt

(19) European Patent Office

Office européen des brevets

(11) Publication number: **0 090 565**
**B1**

(12) **EUROPEAN PATENT SPECIFICATION**

(45) Date of publication of patent specification: 20.09.89

(51) Int. Cl.⁴: **H 01 L 21/90**

(21) Application number: 83301534.0

(22) Date of filing: 18.03.83

(54) **Process for selectively cutting an electrical conductive layer by irradiation with an energy beam.**

(30) Priority: 30.03.82 JP 52100/82

(43) Date of publication of application:
05.10.83 Bulletin 83/40

(45) Publication of the grant of the patent:
20.09.89 Bulletin 89/38

(84) Designated Contracting States:
DE FR GB

(56) References cited:
EP-A-0 025 347
DE-A-2 705 444
US-A-4 238 839

PATENT ABSTRACTS OF JAPAN, vol. 6, no. 16,
(E-92)(894), January 29, 1982 & JP A 56138948
R.C.A. TECHNICAL NOTES, no. 976, September
1974, pages 1.2 - 2.2, PRINCETON, N.J. (US).
J.J. FABULA: "Semiconductor fuse"

(73) Proprietor: FUJITSU LIMITED
1015, Kamikodanaka Nakahara-ku
Kawasaki-shi Kanagawa 211 (JP)

(72) Inventor: Ogawa, Tsutomu
1-21-8 Honkomagome
Bunkyo-ku Tokyo 113 (US)

(74) Representative: Rackham, Stephen Neil et al
GILL JENNINGS & EVERY 53-64 Chancery Lane
London WC2A 1HN (GB)

Courier Press, Leamington Spa, England.

## Description

The present invention relates to a process for selectively cutting an electrical conductive layer by irradiation with an energy beam.

Increasing integration of elements in semiconductor devices such as a dynamic random access memory has made it desirable not to have to scrap an entire semiconductor chip just because of a failure in one element in the chip. Toward this end, semiconductor chips which include "redundant" circuits have been developed. To salvage a chip found to have a faulty element in one cell, one of the redundant circuits is activated to replace the cell with the faulty element and the circuit which leads to the faulty cell is cut. Selective cutting of an electrical conductive layer has been developed to meet this requirement in the production of random access memories (RAMs), read only memories (ROMs), and other devices.

It is well known in the art selectively to cut conductive layers by partial removal of the metallic layer with an etchant or by melting the metallic layer with an excess current. US—A—4,238,839 teaches that selective cutting by a laser beam can be used to program a read only memory after its manufacture. Accurate, selective cutting of a layer can be realised, since scanning of a laser beam can be controlled accurately.

However, the smallest diameter of a practical laser beam is about 3 µm. On the other hand, in an integrated circuit with a high packing density, the width of aluminium wirings and the space between them may be no more than 1 µm. Thus, the spot irradiated by a laser beam covers adjacent wirings and so it is not possible to use such a laser beam to cut a single wiring.

It is also known from DE—A-27 05 444 to heat a solid body which may be an electrically conducting body using an energy beam by initially coating the surface of the body with a material having a greater coefficient of energy absorbtion than the body itself and then irradiating the entire surface of the body.

According to this invention a process for selectively cutting an electrical conductive layer by irradiation with an energy beam, includes the steps of depositing a film of an energy beam absorbing material having a greater energy beam absorbtion than the electrical conductive layer on a portion of the electrical conductive layer to be cut, and then irradiating the film with the energy beam, the film absorbing energy from the energy beam and transferring the absorbed energy to the layer is characterised in that the film of energy absorbing material has a thickness between 0.01 and 0.1 µm and an area smaller than the spot size of a focussed energy beam, so that when the energy beam irradiates the area containing the film it melts the heat absorbing film into the electrically conductive layer and thereby selectively cuts a desired area of the electrically conductive layers coated with the film without cutting adjacent areas.

This invention enables minute sections of an electrical conductive layer to be cut accurately without damaging regions adjacent the cut portion.

Preferably the energy beam is a laser beam. It is convenient when the electrical conductive layer is aluminium for the energy absorbing film to be amorphous silicon, and when the electrical conductive layer is a refractory metal for the heat-absorbing film to be polysilicon or amorphous silicon.

A particular example of a process in accordance with this invention will now be described with reference to the accompanying drawings; in which:-

Figure 1A is a plan of an electrical conductive layer, a portion of which is coated with a heat-absorbing material;

Figure 1B is a section taken along line B—B shown in Figure 1A;

Figure 2 is a plan of a cut electrical conductive layer;

Figures 3A to 3D are detailed sections illustrating the steps of selective cutting the layers according to the present invention;

Figure 4A is a plan of the layers shown in Figure 3D; and,

Figure 4B is a plan after cutting.

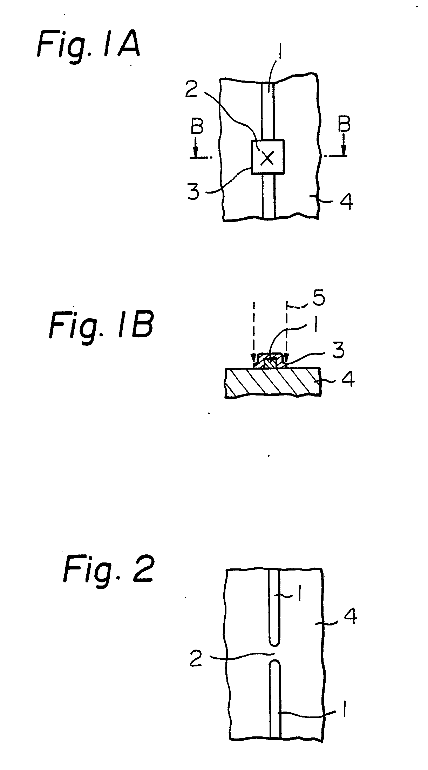

Figures 1A and 1B illustrate the general principle of the invention according to claim 1. A linear aluminum layer 1 is provided on a silicon substrate 4. portion 2 to be cut is coated with an amorphous silicon layer 3 (Fig. 1A). The reflectivity of aluminum and silicon is 0.92 and 0.41, respectively at wave length of 0.5 µm.

The amorphous silicon layer 3 is irradiated by a laser beam 5 (Fig. 1B). The laser beam melts the silicon layer 3 and just the portion of the aluminum layer 1 under the silicon layer 3, while leaving the other portions intact. Surface tension then causes the molten aluminum to separate, completing the cut (Fig. 2). During this process, the silicon becomes alloyed with the molten aluminium.

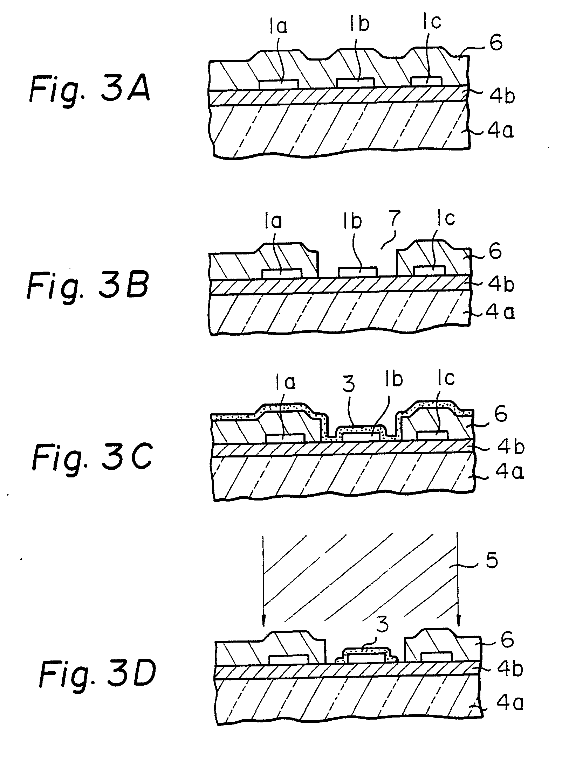

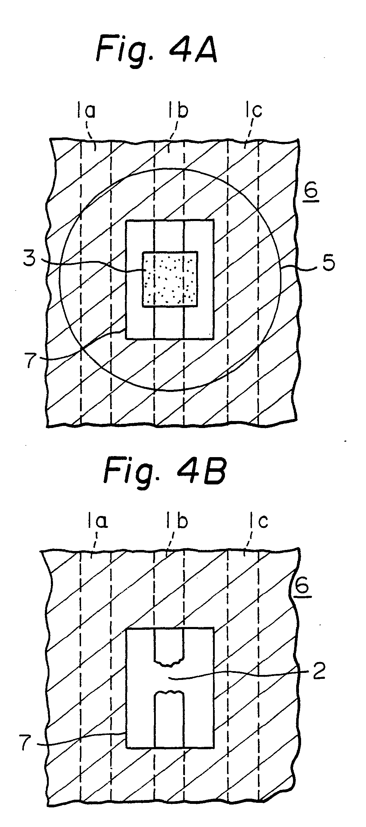

An embodiment of the present invention will now be described in detail referring to Figs. 3A to 3D and Figs. 4A and 4B. Three linear aluminum layers 1a to 1c having 1 µm width and spaced 1 µm from each other are deposited at a thickness of 1 µm on a silicon dioxide film 4b formed on the silicon substrate 4a. A protective phosphorus silicate glass (PSG) film 6 is formed by chemical vapour deposition (Fig. 3A).

A window 7 is opened in the PSG film 6 by etching it with a mixture of hydrogen fluoride and ammonium fluoride solutions. Thus, the portion of aluminum layer 1b to be cut is exposed (Fig. 3B). An amorphous silicon layer 3 is deposited at a thickness of 0.01 to 0.1 µm (Fig. 3C). The layer 3 is then removed, except for the region of aluminum layer 1b to be cut, by plasma etching using tetrafluorocarbon (Fig. 3D). A continuous wave argon laser beam 5 with an intensity of 9 W having a 5 µm beam diameter irradiates for 0.1 second the amorphous silicon layer 3, through

EP 0 090 565 B1

the window 7, and the PSG film 6 surrounding the window 7 (Figs. 3D, 4A).

The amorphous silicon layer 3 and the underlying section of the aluminum layer 1b melt. The aluminum layer 1b is then separated at the portion 2 owing to the surface tension of the molten aluminum. On the other hand, the other aluminum layers 1a and 1c are not affected by the irradiation of the laser beam (Fig. 4B).

In the above-mentioned embodiment, the amorphous silicon layer 3 is deposited on the aluminum layer 1b, whereas the protective PSG film 6 is deposited on the other aluminum layers 1a and 1c (Fig. 3C). In the case where the protective film is silicon oxynitride (SiON) or polyimide, which can be deposited at a relatively low temperature at which aluminum and amorphous silicon do not alloy with each other, such protective films may be deposited after the amorphous silicon layer is deposited on the aluminum layer.

If refractory metals, such as molybdenum, tungsten, and platinum are used as electrical conductive layers, polysilicon having higher melting point may be deposited instead of amorphous silicon.

The present invention enables easy, selective cutting of the electrical conductive layer at the exactly intended portion without damaging other portions, thereby increasing the yield of the products, such as semiconductor devices, and improving the reliability thereof.

## Claims

1. A process for selectively cutting an electrical conductive layer (1) by irradiation with an energy beam, including the steps of depositing a film of an energy beam absorbing material (3) having a greater energy beam absorbtion than the electrical conductive layer (1) on a portion of the electrical conductive layer (1) to be cut, and then irradiating the film with the energy beam (5), the film (3) absorbing energy from the energy beam (5) and transferring the absorbed energy to the layer (1), whereby the film (3) of energy absorbing material has a thickness between 0.01 and 0.1 μm and an area smaller than the spot size of a focussed energy beam (5), so that when the energy beam irradiates the area containing the film (3) it melts the heat absorbing film (3) into the electrically conductive layer (1) and thereby selectively cuts a desired area of the electrically conductive layers coated with the film (3) without cutting adjacent areas.

2. A process according to claim 1, in which the energy beam (5) is a laser beam.

3. A process according to claim 1 or 2, in which the electrical conductive layer (1) is aluminium and in which the heat-absorbing film (3) is amorphous silicon.

4. A process according to claim 1 or 2, in which the electrical conductive layer (1) is a refractory metal, and in which the heat-absorbing film (3) is polysilicon or amorphous silicon.

## Patentansprüche

1. Verfahren zum selektiven Schneiden einer elektrisch leitenden Schicht (1) durch Bestrahlen mit einem Energiestrahl, einschließlich der folgenden Schritte: Abscheiden eines Films aus einem einen Energiestrahl absorbierenden Material (3), welches eine größere Energiestrahl-Absorption als die elektrisch leitende Schicht (1) hat, auf einem Abschnitt der elektrisch leitendem Schicht (1), die geschnitten werden soll, und anschließendes Bestrahlen des Films mit dem Energiestrahl (5), wobei der Film (3) Energie von dem Energiestrahl (5) absorbiert und die absorbierte Energie zu der Schicht (1) überträgt, wodurch der Film (3) aus Energie absorbierendem Material eine Dicke zwischen 0,01 und 0,1 μm und einen Bereich hat, der kleiner als die Punktgröße von einem fokussierten Energiestrahl (5) ist, so daß dann, wenn der Energiestrahl den Bereich bestrahlt, der den Film (3) enthält, er den wärmeabsorbierenden Film (3) in der elektrisch leitenden Schicht (1) schmilzt und dadurch selektiv einen gewünschten Bereich der elektrisch leitenden Schichten, die mit dem Film (3) überzogen sind, schneidet, ohne die benachbarten Bereiche zu schneiden.

2. Verfahren nach Anspruch 1, bei dem der Energiestrahl (5) ein Laserstrahl ist.

3. Verfahren nach Anspruch 1 oder 2, bei dem die elektrisch leitende Schicht (1) Aluminium ist und bei dem der wärmeabsorbierende Film (3) amorphes Silizium ist.

4. Verfahren nach Anspruch 1 oder 2, bei dem die elektrisch leitende Schicht (1) ein hitzebeständiges Metall ist, und bei dem der wärmeabsorbierende Film (3) Polysilizium oder amorphes Silizium ist.

## Revendications

1. Procédé permettant de découper sélectivement une couche électriquement conductrice (1) par irradiation à l'aide d'un faisceau d'énergie, comportant les opérations qui consistent à faire déposer, sur une partie de la couche électriquement conductrice (1) à découper, une pellicule d'un matériau (3) d'absorption du faisceau d'énergie qui possède une plus grande absorption du faisceau d'énergie que la couche électriquement conductrice (1), puis à irradier la pellicule à l'aide du faisceau d'énergie (5), la pellicule (3) absorbant l'énergie du faisceau d'énergie (5) et transférant l'énergie absorbée à la couche (1), où la pellicule (3) du matériau d'absorption d'énergie possède une épaisseur comprise entre 0,01 et 0,1 μm et une aire plus petite que la taille de la tache d'un faisceau d'énergie focalisé (5), si bien que, lorsque le faisceau d'énergie irradie l'aire contenant la pellicule (3), il fait fondre la pellicule d'absorption de chaleur (3) dans la couche électriquement conductrice (1) et découpe ainsi sélectivement une aire voulue de la couche électriquement conductrice revêtue par la pellicule (3) sans découper les aires adjacentes.

3

2. Procédé selon la revendication 1, dans lequel le faisceau d'énergie (5) est un faisceau laser.

3. Procédé selon la revendication 1 ou 2, dans lequel la couche électriquement conductrice (1) est faite d'aluminium et la pellicule d'absorption de chaleur (3) est faite de silicium amorphe.

4. Procédé selon la revendication 1 ou 2, dans lequel la couche èlectriquement conductrice (1) est faite d'un métal réfractaire, et la pellicule d'absorption de chaleur (3) est faite de silicium polycristallin ou de silicium amorphe.

*Fig. 1A*

*Fig. 1B*

*Fig. 2*

*Fig. 3A*

*Fig. 3B*

*Fig. 3C*

*Fig. 3D*

# Fig. 4A

# Fig. 4B